# EUROPEAN PATENT APPLICATION

(11) **EP 4 462 968 A1**
(43) Date of publication of application: **13.11.2024**
(21) Application number: 23918899.8
(22) Date of filing: 29.12.2023
(51) Int. Cl.: H05K 7/20

(54) **HEAT DISSIPATION DEVICE AND POWER CONVERSION DEVICE**

(30) Priority: 30.03.2023 CN 202310358018
(71) Applicant: Huawei Digital Power Technologies Co., Ltd., Shenzhen, Guangdong 518043 (CN)
(72) Inventor: REN, Junheng, Shenzhen Guangdong 518043 (CN); LI, Jiyang, Shenzhen Guangdong 518043 (CN)
(74) Representative: Gill Jennings & Every LLP
(86) International application number: PCT/CN2023/143193
(87) International publication number: WO 2024/198591

(57) **Abstract**

Embodiments of this application provide a heat sink and a power conversion device. The power conversion device includes a housing, a power element, and a heat sink. A mounting cavity is formed in the housing, and the power element is mounted in the mounting cavity. The heat sink includes a thermally conductive plate, the thermally conductive plate is mounted in the housing, the thermally conductive plate includes a first side in a thickness direction of the thermally conductive plate, the first side has a heat source assembly region, and the power element is disposed in the heat source assembly region and is in thermal contact with the thermally conductive plate. The thermally conductive plate has at least one sealed chamber, the chamber is provided with at least two flow channels that are spaced apart, and a two-phase cooling medium is accommodated in the flow channel. The flow channel includes a first end and a second end, the first end and the second end are spaced apart in a second direction, and the first end is located above the second end. In this way, heat exchange efficiency between the two-phase cooling medium and the thermally conductive plate is high, temperature uniformity performance of the thermally conductive plate is good, heat dissipation performance of the heat sink is good, and the power conversion device is not easily faulty due to overheating.

## Description

This application claims priority to Chinese Patent Application No. 202310358018.8, filed with the China National Intellectual Property Administration on March 30, 2023 and entitled "HEAT SINK AND POWER CONVERSION DEVICE", which is incorporated herein by reference in its entirety.

### TECHNICAL FIELD

Embodiments of this application relate to the field of heat sink technologies, and in particular, to a heat sink and a power conversion device.

### BACKGROUND

A power conversion device is an electronic device used to convert a specific current into another type of current, and can be used in fields, such as power generation, power transformation, power distribution, and charging. The power conversion device usually includes a power element like a power diode, and the power element generates heat during operation, so that a temperature of the power conversion device increases. When the temperature of the power conversion device is high, a fault is easy to occur. This affects normal operation of the power conversion device. To dissipate heat generated by the power element, the power conversion device may further include a heat sink, and the heat generated by the power element may be dissipated to an external environment by using the heat sink.

In the conventional technology, heat dissipation performance of the heat sink of the power conversion device is poor. As a size of the power conversion device decreases and power increases, heat flux density in the power conversion device increases, and the heat sink in the conventional technology cannot meet a heat dissipation requirement of the power conversion device.

Therefore, how to improve a heat dissipation capability of the heat sink to enable the heat sink meet a requirement in a scenario with large heat flux density becomes an urgent problem to be resolved.

### SUMMARY

Embodiments of this application provide a heat sink and a power conversion device. A plurality of flow channels accommodating two-phase cooling media are disposed in a thermally conductive plate of the heat sink, so that heat exchange efficiency between the two-phase cooling media and the thermally conductive plate is high, temperature uniformity performance of the thermally conductive plate is good, heat dissipation performance of the heat sink is good, and the power conversion device is not easily faulty due to overheating.

A first aspect of this application provides a power conversion device, including a housing, a power element, and a heat sink. A mounting cavity is formed in the housing, and the power element is mounted in the mounting cavity. The heat sink includes a thermally conductive plate, the thermally conductive plate is mounted in the housing, the thermally conductive plate includes a first side in a thickness direction of the thermally conductive plate, the first side has a heat source assembly region, and the power element is disposed in the heat source assembly region and is in thermal contact with the thermally conductive plate. The thermally conductive plate has at least one sealed chamber, the chamber is provided with at least two flow channels spaced apart in a first direction, and a two-phase cooling medium is accommodated in the flow channel. The flow channel includes a first end and a second end, the first end and the second end are spaced apart in a second direction, and the first end is located above the second end. Both the first direction and the second direction are perpendicular to the thickness direction of the thermally conductive plate, and the first direction is perpendicular to the second direction.

According to the heat sink in this embodiment of this application, the two-phase cooling medium in each flow channel may perform heat exchange with the thermally conductive plate through a flow channel wall of the flow channel in which the two-phase cooling medium is located, and a heat exchange area between the thermally conductive plate and the two-phase cooling medium in the thermally conductive plate is large. This helps improve heat exchange efficiency between the two-phase cooling medium and the thermally conductive plate. In addition, a cross-sectional area for flow of the two-phase cooling medium in the flow channel is small, so that a flow speed of the two-phase cooling medium is fast, and convection of the two-phase cooling medium is more intense. This helps further improve the heat exchange efficiency between the two-phase cooling medium and the thermally conductive plate. After the heat exchange efficiency between the two-phase cooling medium and the thermally conductive plate is improved, temperature uniformity performance of the thermally conductive plate is better, heat dissipation performance of the heat sink is improved, and the power conversion device is not easily faulty due to overheating.

In a possible implementation, in a same chamber, first ends of all flow channels meet, and second ends of all flow channels meet.

In a possible implementation, the chamber includes a first sub-cavity and a second sub-cavity. In the same chamber, the first sub-cavity is located at an upper end of the chamber, the second sub-cavity is located at a lower end of the chamber, the flow channel is located between the first sub-cavity and the second sub-cavity, the first end of the flow channel is communicated with the first sub-cavity, the first ends of all the flow channels meet by using the first sub-cavity, the second end of the flow channel is communicated with the second sub-cavity, and the second ends of all the flow channels meet by using the second sub-cavity.

In a possible implementation, a confluence channel is disposed between at least one pair of two adjacent flow channels in the same cavity, and two ends of the confluence channel are respectively communicated with the two adjacent flow channels. In the same flow channel, an intersection of the confluence channel and the flow channel is located below the first end and above the second end.

In a possible implementation, there are at least two chambers in the thermally conductive plate, and different chambers are separated from each other.

In a possible implementation, the thermally conductive plate further includes a second side opposite to the first side. There is a separation part between two adjacent flow channels, two ends of the separation part in the thickness direction of the thermally conductive plate are respectively connected to the first side and the second side, and the flow channel is formed between the separation part and a chamber wall of the chamber.

In a possible implementation, the separation part, the first side, and the second side are of an integrated structure.

In a possible implementation, the flow channel is a direct flow channel extending in the second direction.

In a possible implementation, the thermally conductive plate includes a plate member and an end cover, the flow channel is located in the plate member, and the flow channel passes through two ends of the plate member in the second direction. The two ends of the plate member in the second direction are covered with end covers, and the chamber is formed between the end covers of the two ends of the plate member and an inner wall of the plate member.

In a possible implementation, a flow channel wall of the flow channel has a concave-convex structure.

In a possible implementation, a first heat exchange structure is disposed on the second side of the thermally conductive plate.

In a possible implementation, the first heat exchange structure includes a first toothed fin, and the first toothed fin is connected to the second side.

In a possible implementation, the first toothed fin is a straight toothed fin whose two ends extend in the second direction.

In a possible implementation, the first heat exchange structure includes a plurality of first toothed fins that are spaced apart in the first direction. The first heat exchange structure further includes a fin disposed between two adjacent first toothed fins, and two ends of the fin are respectively connected to the adjacent first toothed fins on two sides.

In a possible implementation, a second heat exchange structure is disposed on the first side.

In a possible implementation, the second heat exchange structure includes a second toothed fin, and the second toothed fin is connected to the first side.

In a possible implementation, the second toothed fin is a straight toothed fin whose two ends extend in the second direction.

In a possible implementation, the second heat exchange structure is located outside the heat source assembly region.

A second aspect of embodiments of this application provides a heat sink, including a thermally conductive plate. The thermally conductive plate has at least one sealed chamber, the chamber is provided with at least two flow channels spaced apart in a first direction, and a two-phase cooling medium is accommodated in the flow channel. The flow channel includes a first end and a second end, and the first end and the second end are spaced apart in a second direction. Both the first direction and the second direction are perpendicular to a thickness direction of the thermally conductive plate, and the first direction is perpendicular to the second direction.

### BRIEF DESCRIPTION OF DRAWINGS

FIG. 1 is a schematic perspective diagram of a power conversion device on a side in a first direction according to an embodiment of this application;
FIG. 2 is a schematic perspective diagram of a power conversion device on a side in a second direction according to an embodiment of this application;
FIG. 3 is a schematic perspective diagram of an air duct shell of a power conversion device and a heat sink mounted in the power conversion device on a side that a second side faces according to an embodiment of this application;
FIG. 4 is a schematic perspective diagram of a power conversion module and a heat sink of a power conversion device on a side in a second direction according to an embodiment of this application;
FIG. 5 is a schematic perspective diagram of a thermally conductive plate of a heat sink on a side that a second side faces according to an embodiment of this application;
FIG. 6 is a schematic perspective diagram of another thermally conductive plate of a heat sink on a side that a second side faces according to an embodiment of this application;
FIG. 7 is a schematic perspective diagram of still another thermally conductive plate of a heat sink on a side that a second side faces according to an embodiment of this application;
FIG. 8 is a schematic cross-sectional diagram of still another heat sink according to an embodiment of this application;
FIG. 9 is a schematic diagram of still another heat sink on a side that a second side faces according to an embodiment of this application;
FIG. 10 is a schematic perspective diagram of a thermally conductive plate of still another heat sink on a side that a second side faces according to an embodiment of this application;
FIG. 11 is a schematic cross-sectional diagram of still another heat sink according to an embodiment of this application;
FIG. 12 is a schematic cross-sectional diagram of still another heat sink according to an embodiment of this application;
FIG. 13 is a schematic cross-sectional diagram of still another heat sink according to an embodiment of this application;
FIG. 14 is a schematic perspective diagram of a power conversion module and a heat sink of still another power conversion device on a side in a second direction according to an embodiment of this application;
FIG. 15 is a schematic diagram of still another heat sink on a side that a first side faces according to an embodiment of this application;
FIG. 16 is a schematic perspective diagram of a thermally conductive plate of still another heat sink on a side that a second side faces according to an embodiment of this application;
FIG. 17 is a schematic cross-sectional diagram of still another heat sink according to an embodiment of this application; and
FIG. 18 is a schematic perspective diagram of a thermally conductive plate of still another heat sink on a side that a second side faces according to an embodiment of this application.

### Descriptions of reference numerals:

10: heat sink;
20: power conversion module; 21: housing; 22: circuit board; 23: power element; 24: mounting cavity;
30: fan;
40: air duct shell; 41: air duct; 42: air outlet; 43: air inlet;
100: thermally conductive plate;
110: plate member;
120: end cover;
130: chamber; 131: flow channel; 132: first end; 133: second end; 134: first sub-cavity; 135: second sub-cavity; 136: separation part; 137: concave-convex structure; 138: confluence channel;
140: first side; 141: heat source assembly region;
150: second side;
200: first heat exchange structure; 210: first toothed fin; 220: fin;
300: two-phase cooling medium;
400: second heat exchange structure; 410: second toothed fin;
x: first direction; y: second direction; and z: thickness direction of a thermally conductive plate.

### DESCRIPTION OF EMBODIMENTS

Terms used in embodiments of this application are only used to explain specific embodiments of this application, and are not intended to limit this application. The following describes implementations of embodiments of this application in detail with reference to accompanying drawings.

A power conversion device is an electronic device used to convert a specific current into another type of current, and can be used in fields, such as power generation, power transformation, power distribution, and charging.

The power conversion device provided in embodiments of this application may include but is not limited to an inverter, a rectifier, and the like. An inverter in a power station is used as an example for description in this embodiment of this application.

It may be understood that the power station may include but is not limited to a photovoltaic power station, a wind power station, a hydroelectric power station, a geothermal power station, a thermal power station, and the like.

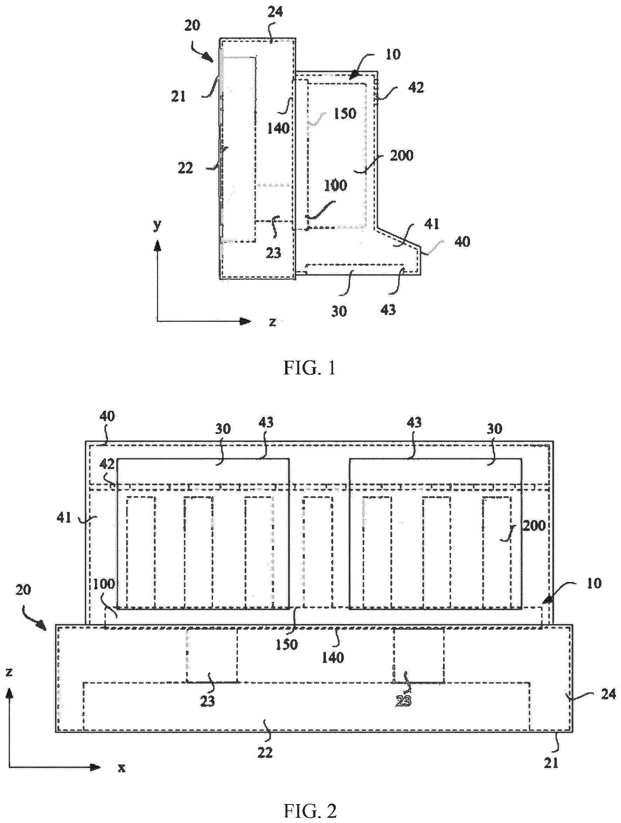

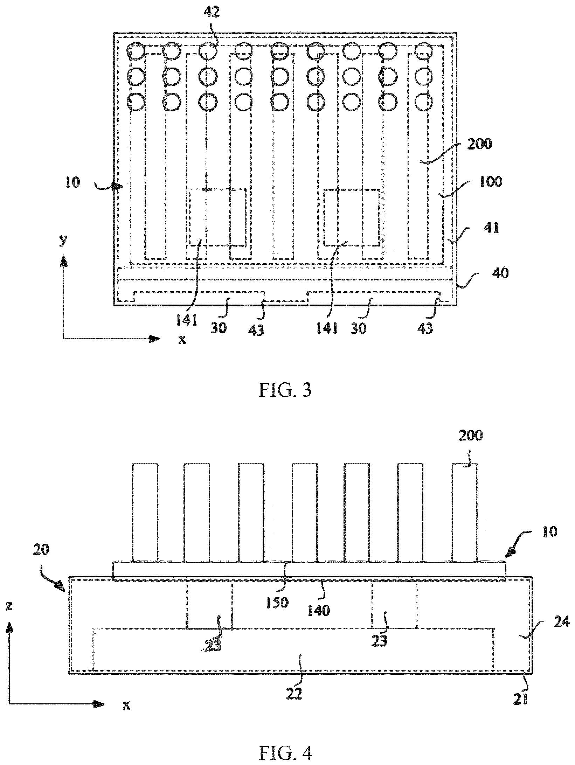

FIG. 1 is a schematic perspective diagram of a power conversion device on a side in a first direction according to an embodiment of this application. FIG. 2 is a schematic perspective diagram of a power conversion device on a side in a second direction according to an embodiment of this application. FIG. 3 is a schematic perspective diagram of an air duct shell of a power conversion device and a heat sink mounted in the power conversion device on a side that a second side faces according to an embodiment of this application. FIG. 4 is a schematic perspective diagram of a power conversion module and a heat sink of a power conversion device on a side in a second direction according to an embodiment of this application.

As shown in FIG. 1 to FIG. 4, in this embodiment of this application, the power conversion device includes a power conversion module 20. The power conversion module 20 includes a housing 21, a circuit board 22, and a power element 23. A mounting cavity 24 is formed in the housing 21, and the circuit board 22 and the power element 23 are mounted in the mounting cavity 24. The power element 23 is mounted on the circuit board 22, and the power element 23 is electrically connected to the circuit board 22.

It may be understood that the power element 23 may include but is not limited to a power diode, an insulated gate bipolar transistor (Insulated Gate Bipolar Transistor, IGBT), a metal-oxide-semiconductor field-effect transistor (Metal-Oxide-Semiconductor Field-Effect Transistor, MOSFET), and the like.

It may be understood that the housing 21 may be made of a material with good thermal conductivity, for example, aluminum, stainless steel, or aluminum alloy, and heat generated by the power element 23 in the mounting cavity 24 may be dissipated outward through the housing 21.

To improve a heat dissipation capability of the power conversion module 20, in this embodiment of this application, the power conversion device may further include a heat sink 10. The heat sink 10 is mounted on the housing 21, and the power element 23 is configured to perform heat dissipation by using the heat sink 10. Specifically, the housing 21 is provided with an opening for mounting the heat sink 10, the opening communicates with the mounting cavity 24, the heat sink 10 is mounted at the opening, a part of the heat sink 10 is located in the mounting cavity 24, and a part of the heat sink 10 is located outside the housing 21. The part that is of the heat sink 10 and that is located in the mounting cavity 24 has a heat source assembly region 141, and the power element 23 is disposed in the heat source assembly region 141 and is in thermal contact with the heat sink 10, to perform heat exchange with the part that is of the heat sink 10 and that is located in the mounting cavity 24. The part that is of the heat sink 10 and that is located outside the housing 21 is configured to exchange heat with an environment outside the housing 21, and heat generated by the power element 23 in the mounting cavity 24 may be dissipated outside the housing 21 by using the heat sink 10. The power element 23 in the mounting cavity 24 may be attached to the heat source assembly region 141 of the heat sink 10. For example, the power element 23 in the mounting cavity 24 may be in contact with the heat source assembly region 141 of the heat sink 10. Alternatively, the power element 23 in the mounting cavity 24 may be connected to the heat source assembly region 141 of the heat sink 10 by using a thermal interface material (Thermal Interface Material, TIM).

To improve heat dissipation performance of the heat sink 10, in this embodiment of this application, the power conversion device may further include a fan 30. The fan 30 is disposed outside the housing 21, and the fan 30 is configured to accelerate air flow at the part that is of the heat sink 10 and that is outside the housing 21, to improve heat exchange efficiency between the part that is of the heat sink 10 and that is located outside the housing 21 and air outside the housing 21.

It may be understood that the power conversion device may include one or more fans 30. A quantity and positions of the fans 30 may be set based on an actual application scenario. This is not specifically limited herein.

In this embodiment of this application, the power conversion device may further include an air duct shell 40. The air duct shell 40 is disposed on an outer wall of the housing 21, an air duct 41 is formed between the air duct shell 40 and the housing 21, and the part that is of the heat sink 10 and that is located outside the housing 21 is in the air duct 41. The air duct shell 40 is provided with an air inlet 43 and an air outlet 42. The air inlet 43 and the air outlet 42 are the same as the air duct 41, and the air inlet 43 and the air outlet 42 are respectively located at two ends of the air duct 41. The fan 30 may be disposed at the air inlet 43, and the fan 30 is fixedly connected to the air duct shell 40. The fan 30 is configured to suck air outside the air duct shell 40 into the air duct 41 through the air inlet 43, and blow air towards the part that is of the heat sink 10 and that is outside the housing 21. Air in the air duct 41 may be discharged through the air outlet 42.

It may be understood that forms of the air duct shell 40 and the air duct 41 may be set based on an actual application scenario. This is not limited herein.

For example, the air duct 41 may include a first section, a second section, and a guide section. The air inlet 43 is disposed at one end of the first section, the other end of the first section is connected to one end of the second section by using the guide section, and the air outlet 42 is disposed at the other end of the second section. The fan 30 is mounted on the first section, the air outlet 42 may be provided on a side that is of the second section and that is away from the housing 21, the part that is of the heat sink 10 and that is located outside the housing 21 is accommodated in the second section, and a through-flow area of the first section is greater than a through-flow area of the second section. A through-flow area of the guide section gradually decreases from one end facing the first section to one end facing the second section, and the guide section is configured to converge air blown by the fan 30 towards the second section.

It may be understood that a plurality of air outlets 42 distributed in an array may be disposed on the side that is of the second section and that is away from the housing 21.

In this embodiment of this application, the heat sink 10 may include a thermally conductive plate 100, and the thermally conductive plate 100 is mounted on the housing 21. Specifically, the thermally conductive plate 100 is mounted at the opening provided on the housing 21. The thermally conductive plate 100 includes a first side 140 and a second side 150 that are opposite in a thickness direction of the thermally conductive plate 100. The first side 140 faces the power element 23 and is located in the mounting cavity 24, the first side 140 has a heat source assembly region 141, and the power element 23 is disposed in the heat source assembly region 141 and is in thermal contact with the thermally conductive plate 100, to perform heat exchange with the first side 140 of the thermally conductive plate 100. The second side 150 is located outside the housing 21 and inside the air duct 41. The second side 150 is configured to perform heat exchange with air in the air duct 41. Heat that is generated by the power element 23 and that is absorbed by the first side 140 may be dissipated into the air in the air duct 41 through the second side 150, in other words, the power element 21 is configured to dissipate heat by using the thermally conductive plate 100 of the heat sink 10. The fan 30 may be configured to drive flow of air in the air duct 41, so that air with a high temperature that absorbs heat of the second side 150 is discharged from the air duct 41 through the air outlet 42, and air with a low temperature is sucked into the air duct 41 from the air inlet 43.

It may be understood that a plurality of air inlets 43 may be spaced apart in the first direction on the air duct shell 40, and one fan 30 may be disposed at each air inlet 43. The first direction is perpendicular to the thickness direction of the thermally conductive plate 100.

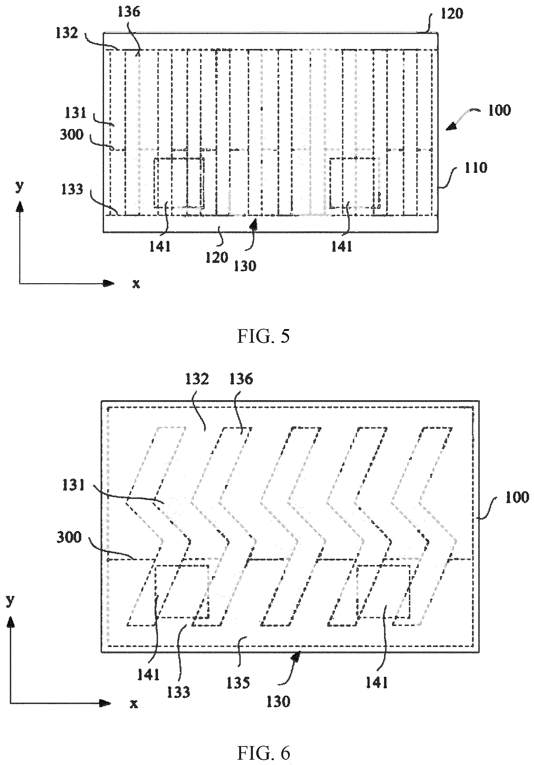

FIG. 5 is a schematic perspective diagram of a thermally conductive plate of a heat sink on a side that a second side faces according to an embodiment of this application.

As shown in FIG. 5, in this embodiment of this application, the thermally conductive plate 100 has a sealed chamber 130, the chamber 130 may accommodate a two-phase cooling medium 300, and the two-phase cooling medium 300 in the chamber 130 may perform heat exchange with the first side 140 and the second side 150 of the thermally conductive plate 100. Heat transfer in the thermally conductive plate 100 can be accelerated by a phase change of the two-phase cooling medium 300, so that a temperature difference between the thermally conductive plate 100 near the power element 23 and the thermally conductive plate 100 away from the power element 23 is small in a flow direction of the two-phase cooling medium 300. Heat dissipation effect of the heat sink 10 may be improved by improving temperature uniformity of the thermally conductive plate 100.

It may be understood that, after the heat sink 10 is assembled, the thermally conductive plate 100 may be vertically disposed. In this case, the thickness direction of the thermally conductive plate 100 and the first direction may be two mutually perpendicular horizontal directions. The power element 23 may be attached to a lower part of the thermally conductive plate 100, and a position where the power element 23 is disposed on the thermally conductive plate 100 is in contact with the two-phase cooling medium 300 in a liquid phase. In other words, the position where the power element 23 is disposed on the thermally conductive plate 100 is below a liquid level of the two-phase cooling medium 300 in the corresponding chamber 130. After the two-phase cooling medium 300 at the position of the power element 23 absorbs heat generated by the power element 23, a part of two-phase cooling medium 300 in the liquid phase evaporates into a gas phase, and the two-phase cooling medium 300 in the gas phase rises to an upper part of the chamber 130. After the two-phase cooling medium 300 in the gas phase exchanges heat with a chamber wall of the upper part of the chamber 130 with a low temperature, the two-phase cooling medium 300 in the gas phase condenses into a liquid phase, and flows back to a lower part of the chamber 130 under an action of gravity. Circulation is performed in such a way, so that heat at a position where the power element 23 is disposed on the thermally conductive plate 100 may be migrated to an upper part that is of the thermally conductive plate 100 and that is away from the power element 23. This improves temperature uniformity performance of the thermally conductive plate 100, and improves the heat dissipation effect of the heat sink 10.

A person skilled in the art may understand that vertical in this application does not mean absolutely vertical to the ground, and a small error is allowed. For example, vertical may be a direction in which an included angle with the ground is 88°, 85°, or the like.

A person skilled in the art may understand that horizontal in this application does not mean absolutely parallel to the ground, and a small error is allowed. For example, horizontal may be a direction in which an included angle with the ground is 175°, 178°, or the like.

For example, the two-phase cooling medium 300 may include one or more of hydrofluoroether, fluoroketone, hydrofluoroolefin, perfluorocarbon, perfluoromethylmorpholine, and the like.

In the conventional technology, a chamber containing a two-phase cooling medium in the thermally conductive plate is a cavity with a large size, no other structure is disposed in the chamber, and the two-phase cooling medium in the chamber exchanges heat with the thermally conductive plate through chamber walls on four sides of the chamber. A heat exchange area between the two-phase cooling medium in the chamber and the thermally conductive plate is small, a cross-sectional area for flow of the two-phase cooling medium in the cavity is large, and a flow rate of the two-phase cooling medium in the chamber is slow. Small heat exchange area and slow flow rate of the two-phase cooling medium lead to low heat exchange efficiency between the two-phase cooling medium in the chamber and the thermally conductive plate, and temperature uniformity performance of the thermally conductive plate and heat dissipation effect of the heat sink need to be improved. As the power conversion device develops towards miniaturization and high power, heat flux density in the power conversion module increases, and the heat sink in the conventional technology cannot meet a heat dissipation requirement of the power conversion module.

As shown in FIG. 5, based on this, in this embodiment of this application, at least two flow channels 131 that are spaced apart in the first direction are disposed in the chamber 130 of the thermally conductive plate 100, and the two-phase cooling medium 300 is accommodated in the flow channel 131. The flow channel 131 includes a first end 132 and a second end 133. The first end 132 and the second end 133 are spaced apart in the second direction. After the heat sink 10 is assembled on the power conversion module 20, the first end 132 is located above the second end 133. The second direction is perpendicular to the thickness direction of the thermally conductive plate 100, and the first direction is perpendicular to the second direction.

It may be understood that after the heat sink 10 is assembled on the power conversion module 20, the thermally conductive plate 100 may be vertically disposed. In this case, the first direction may be a horizontal direction, and the second direction may be a vertical direction.

It may be understood that, after the heat sink 10 is assembled on the power conversion module 20, the thermally conductive plate 100 may alternatively be disposed inclined to a horizontal plane.

It may be understood that the heat source assembly region 141 is located at a position corresponding to lower parts of one or more flow channels 131.

It may be understood that the two-phase cooling medium 300 may perform heat exchange with the first side 140 and the second side 150 of the thermally conductive plate 100 through a flow channel wall of the flow channel 131.

It may be understood that the two-phase cooling medium 300 in the liquid phase in the flow channel 131 may evaporate into the gas phase after absorbing heat emitted by the power element 23, and may flow in the flow channel 131 in which the two-phase cooling medium 300 is located towards the first end 132 of the flow channel 131. A temperature of the thermally conductive plate 100 at the first end 132 is low, the two-phase cooling medium 300 in the gas phase is condensed into the liquid phase after flowing to the first end 132, and the two-phase cooling medium 300 in the liquid phase flows towards the second end 133 under gravity. Heat can be transferred on the thermally conductive plate 100 in the second direction by using the two-phase cooling medium 300.

In this way, the two-phase cooling medium 300 in each flow channel 131 can perform heat exchange with the thermally conductive plate 100 through the flow channel wall of the flow channel 131, and a heat exchange area between the two-phase cooling medium 300 and the thermally conductive plate 100 is large. This helps improve heat exchange efficiency between the two-phase cooling medium 300 and the thermally conductive plate 100. In addition, a cross-sectional area for flow of the two-phase cooling medium 300 in the flow channel 131 is small, so that the two-phase cooling medium 300 flows fast, and convection of the two-phase cooling medium 300 is intense. This helps further improve heat exchange efficiency between the two-phase cooling medium 300 and the thermally conductive plate 100. After the heat exchange efficiency between the two-phase cooling medium and the thermally conductive plate 100 is improved, temperature uniformity performance of the thermally conductive plate 100 is better, heat dissipation performance of the heat sink 10 is improved, and the power conversion device is not easily faulty due to overheating.

It may be understood that both the first end 132 and the second end 133 of the flow channel 131 may be sealed ends, or both may be open ends.

It may be understood that the flow channel 131 may be a direct flow channel, or may be a bent flow channel.

It may be understood that, in the same chamber 130, all the flow channels 131 may be parallel to each other, or at least some of the flow channels 131 may be non-parallel.

For example, a plurality of mutually spaced pipes may be laid in the chamber 130, so that an inner cavity of each pipe may form a flow channel 131, and the pipe may be connected to the first side 140 and the second side 150. In this case, a flow channel wall of the flow channel 131 is a pipe wall of the pipe. The two-phase cooling medium 300 in the pipe may exchange heat with the first side 140 and the second side 150 through the pipe.

FIG. 6 is a schematic perspective diagram of a thermally conductive plate of a heat sink on a side that a second side faces according to an embodiment of this application.

As shown in FIG. 6, in this embodiment of this application, in the same chamber 130, first ends 132 of all flow channels 131 meet, and second ends 133 of all flow channels 131 meet.

In this way, in the same chamber 130, the two-phase cooling medium 300 in the gas phase may flow between different flow channels 131 through the first ends 132 that meet each other, and the two-phase cooling medium 300 in the liquid phase may flow between different flow channels 131 through the second ends 133 that meet each other. Heat can be transferred in the first direction on the thermally conductive plate 100 by using the two-phase cooling medium 300. In addition, in the same chamber 130, the two-phase cooling media 300 in the liquid phase in different flow channels 131 may be complementary to each other through the second ends 133 that meet each other, and the two-phase cooling medium 300 in the gas phase may flow into another flow channel 131 through the first ends 132 that meet each other. In this way, the heat exchange efficiency is less likely to be lowered because two-phase cooling media 300 in a specific flow channel 131 are in the gas phase, and the heat exchange efficiency between the two-phase cooling medium 300 and the thermally conductive plate 100 can be high.

It may be understood that, in the same chamber 130, the first ends 132 of all the flow channels 131 meet, and after the second ends 133 of all the flow channels 131 meet, liquid levels of the two-phase cooling media 300 in different flow channels 131 are the same.

In this embodiment of this application, the chamber 130 includes a first sub-cavity 134 and a second sub-cavity 135. In the same chamber 130, the first sub-cavity 134 and the second sub-cavity 135 are respectively located at two ends of the chamber 130 in the second direction. In other words, the first sub-cavity 134 is located at an upper end of the chamber 130, and the second sub-cavity 135 is located at a lower end of the chamber 130. The flow channel 131 is located between the first sub-cavity 134 and the second sub-cavity 135, the first end 132 of the flow channel 131 is communicated with the first sub-cavity 134, the first ends 132 of all the flow channels 131 meet by using the first sub-cavity 134, the second end 133 of the flow channel 131 is communicated with the second sub-cavity 135, and the second ends 133 of all the flow channels 131 meet by using the second sub-cavity 135.

It may be understood that the two-phase cooling medium 300 may perform heat exchange with the first side 140 and the second side 150 through cavity walls of the first sub-cavity 134 and the second sub-cavity 135.

It may be understood that, after the heat sink 10 is assembled on the power conversion module 20, the first sub-cavity 134 is located above the flow channel 131 communicated with the first sub-cavity 134, and the second sub-cavity 135 is located below the flow channel 131 communicated with the second sub-cavity 135. The two-phase cooling medium 300 in the gas phase may be condensed in the first sub-cavity 134, and the two-phase cooling medium 300 in the liquid phase in the first sub-cavity 134 may flow into any flow channel 131 communicated with the first sub-cavity 134.

In this way, this facilitates mutual flow of the two-phase cooling media 300 in different flow channels 131 in the same chamber 130. In addition, forming of the first sub-cavity 134 and the second sub-cavity 135 are easy, so that the first ends 132 of all the flow channels 131 in the same chamber 130 meet and the second ends 133 of all the flow channels 131 in the same chamber 130 meet.

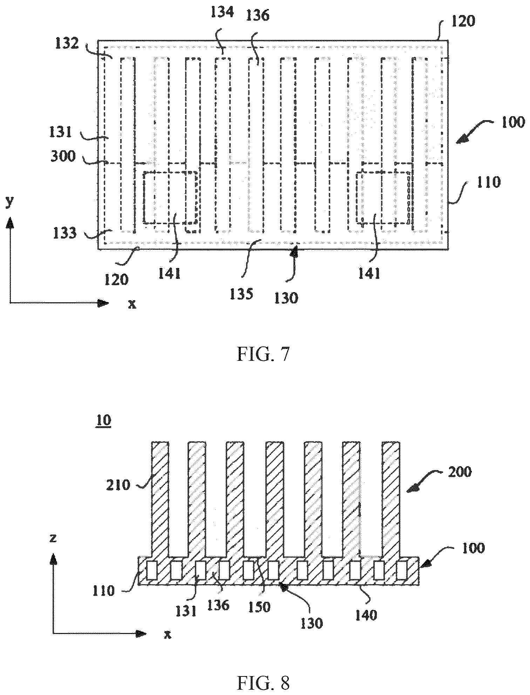

FIG. 7 is a schematic perspective diagram of a thermally conductive plate of still another heat sink on a side that a second side faces according to an embodiment of this application. FIG. 8 is a schematic cross-sectional diagram of still another heat sink according to an embodiment of this application.

As shown in FIG. 7 and FIG. 8 and with reference to FIG. 5 and FIG. 6, in this embodiment of this application, there is a separation part 136 between two adjacent flow channels 131, and two ends of the separation part 136 in the thickness direction of the thermally conductive plate 100 are respectively connected to the first side 140 and the second side 150. The flow channel 131 is formed between the separation part 136 and the chamber wall of the chamber 130.

It may be understood that the two-phase cooling medium 300 is in contact with the separation part 136 and the chamber wall of the chamber 130.

It may be understood that, in the same chamber 130, two flow channels 131 located at two ends in the first direction may be formed by the separation part 136, a chamber wall of the chamber 130 in the first direction, and a chamber wall of the chamber 130 in the thickness direction of the thermally conductive plate 100. A remaining flow channel 131 may be formed by adjacent separation parts 136 on two sides of the flow channel 131 and a chamber wall of the chamber 130 in the thickness direction of the thermally conductive plate 100.

It may be understood that the first side 140 may exchange heat with the second side 150 through the separation part 136, and the two-phase cooling medium 300 in the flow channel 131 may exchange heat with the separation part 136, and exchange heat with the first side 140 and the second side 150 through the separation part 136.

In this way, a part of heat that is generated by the power element 23 and that is absorbed by the first side 140 may be transferred to the second side 150 through the separation part 136, and heat transfer efficiency in the thickness direction of the thermally conductive plate 100 is high. This helps improve heat dissipation performance of the heat sink 10. In addition, heat transfer efficiency between the two-phase cooling medium 300 and the first side 140 and the second side 150 is also high. This facilitates evaporation and condensation of the two-phase cooling medium 300.

It may be understood that a part of heat that is generated by the power element 23 and that is absorbed by the first side 140 may be transferred to the second side 150 through the separation part 136, and another part may be migrated through the two-phase cooling medium 300, to improve temperature uniformity performance of the thermally conductive plate 100. During migration of heat through the two-phase cooling medium 300, heat is also transferred to the second side 150 through the contacting separation part 136 and the chamber wall of the chamber 130.

It may be understood that in an embodiment in which the flow channel 131 is formed between the separation part 136 and the chamber wall of the chamber 130, the flow channel wall of the flow channel 131 includes the chamber wall of the chamber 130 and the separation part 136 for forming the flow channel 131.

In some embodiments of this application, the thermally conductive plate 100 may include a first plate body and a second plate body that are opposite in the thickness direction of the thermally conductive plate 100. A side that is of the first plate body and that is away from the second plate body is the second side 150, and a side that is of the second plate body and that is away from the first plate body is the first side 140. A first groove for forming the flow channel 131, the first sub-cavity 134, and the second sub-cavity 135 is provided on a side that is of the first plate body and that faces the second plate body. After the first plate body and the second plate body are spliced, the first groove and a side that is of the second plate body and that faces the first plate body form the flow channel 131, the first sub-cavity 134, and the second sub-cavity 135. In this case, the first plate body may include a separation part 136, and the separation part 136 is spliced with the second plate body, or the first plate body may include a part of the separation part 136, and the second plate body may include a part of the separation part 136. After the first plate body and the second plate body are spliced, a part that is of the separation part 136 and that is located on the first plate body and a part that is of the separation part 136 and that is located on the second plate body are spliced together to form the separation part 136.

It may be understood that the side that is of the second plate body and that faces the first plate body may be a plane. A second groove corresponding to the first groove may also be provided on the side that is of the second plate body and that faces the first plate body. The first groove and the corresponding second groove may be spliced to form the flow channel 131, the first sub-cavity 134, and the second sub-cavity 135.

In some embodiments of this application, the separation part 136, the first side 140, and the second side 150 are of an integrated structure.

In this way, in comparison with a solution in which the separation part 136 needs to be spliced with at least one of the first side 140 and the second side 150 or the separation part 136 needs to be formed through splicing, when the separation part 136, the first side 140, and the second side 150 are of an integrated structure, heat transfer efficiency of the first side 140 and the second side 150 through the separation part 136 is high, and thermal conductivity of the thermally conductive plate 100 in the thickness direction of the thermally conductive plate 100 is good, so that the heat dissipation effect of the heat sink 10 is good.

In this embodiment of this application, the flow channel 131 is a direct flow channel extending in the second direction.

In this way, forming of the flow channel 131 is easy. This facilitates forming of the flow channel 131 through extrusion, and manufacturing costs of the heat sink 10 are low.

It may be understood that, when the flow channel 131 is a direct flow channel extending in the second direction, all the flow channels 131 are parallel to each other.

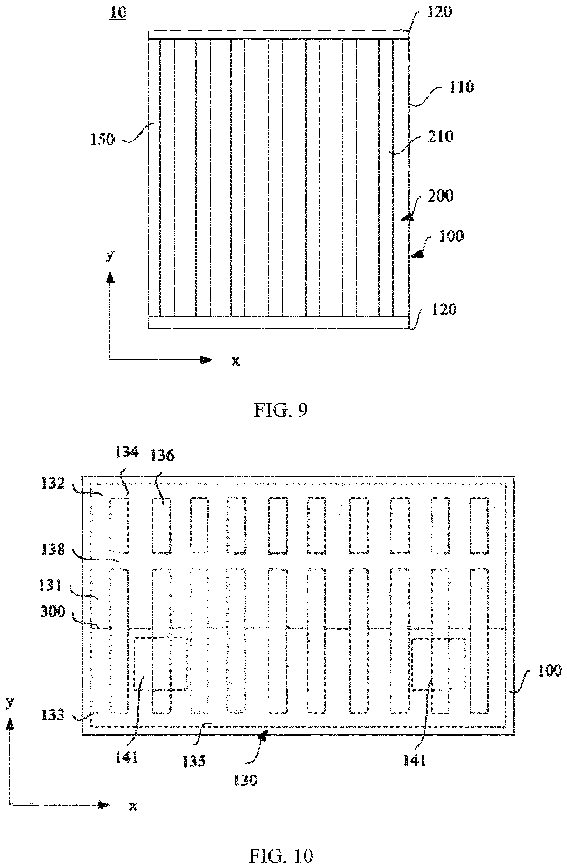

FIG. 9 is a schematic diagram of still another heat sink on a side that a second side faces according to an embodiment of this application.

As shown in FIG. 9 and with reference to FIG. 5 and FIG. 7, in some embodiments in which the flow channel 131 is a direct flow channel extending in the second direction, the thermally conductive plate 100 may include a plate member 110 and an end cover 120, and the flow channel 131 is located in the plate member 110. The flow channel 131 passes through two ends of the plate member 110 in the second direction. The two ends of the plate member 110 in the second direction are covered with end covers 120, and the chamber 130 is formed between the end covers 120 at the two ends of the plate member 110 and an inner wall of the plate member 110.

It may be understood that the plate member 110 may include the first side 140, the second side 150, and the separation part 136, and each segment of the separation part 136 may extend to both ends of the plate member 110 in the second direction.

In this way, the first side 140, the second side 150, and the separation part 136 that are of an integrated structure may be formed through one-time extrusion, and forming of the thermally conductive plate 100 having the flow channel 131 in the chamber 130 is easy. The thermally conductive plate 100 including the sealed chamber 130 may be formed by extruding the plate member 110 having the direct flow channel and then capping the end covers 120 at both ends of the plate member 110.

It may be understood that the plate member 110 and the end cover 120 may be fixed through welding, and materials of the plate member 110 and the end cover 120 may be the same. For example, both the plate member 110 and the end cover 120 may be made of aluminum.

It may be understood that, in an embodiment in which the chamber 130 includes the first sub-cavity 134 and the second sub-cavity 135, a third groove is provided on a side that is of the end cover 120 and that faces the plate member 110, and the chamber 130 is formed between third grooves of the end covers 120 at two ends of the plate member 110 and the inner wall of the plate member 110. The first sub-cavity 134 is formed between the third groove of the end cover 120 located at one end of the plate member 110 and an end face adjacent to the plate member 110, and the second sub-cavity 135 is formed between the third groove of the end cover 120 located at the other end of the plate member 110 and the end face adjacent to the plate member 110.

It may be understood that a plurality of chambers 130 that are spaced apart in the first direction and separated from each other may be formed between the end covers 120 at both ends of the plate member 110 and the inner wall of the plate member 110.

FIG. 10 is a schematic perspective diagram of a thermally conductive plate of still another heat sink on a side that a second side faces according to an embodiment of this application.

As shown in FIG. 10, in an embodiment in which first ends 132 of all flow channels 131 meet and second ends 133 of all flow channels 131 meet in the same chamber 130, a confluence channel 138 is disposed between at least one pair of two adjacent flow channels 131 in the same chamber 130. Two ends of the confluence channel 138 are respectively communicated with the two adjacent flow channels 131. In the same flow channel 131, in the second direction, an intersection of the confluence channel 138 and the flow channel 131 is located between the first end 132 and the second end 133. In other words, in the same flow channel 131, the intersection of the confluence channel 138 and the flow channel 131 is located below the first end 132 and above the second end 133.

In this way, between the two flow channels 131 communicated through the confluence channel 138, the two-phase cooling medium 300 in the gas phase can converge in advance before reaching the first end 132, thereby improving heat exchange efficiency between the two-phase cooling media 300 in different flow channels 131. This improves temperature uniformity performance of the thermally conductive plate 100.

It may be understood that, in the same chamber 130, the confluence channel 138 may be disposed between all two adjacent interflow channels 131. Alternatively, the confluence channel 138 may be disposed between some of two adjacent interflow channels 131, and no confluence channel 138 may be disposed between some of two adjacent interflow channels 131.

It may be understood that a groove communicating two adjacent flow channels 131 may be provided on the first plate body on which the first groove is provided, to form the confluence channel 138 after the first plate body and the second plate body are spliced.

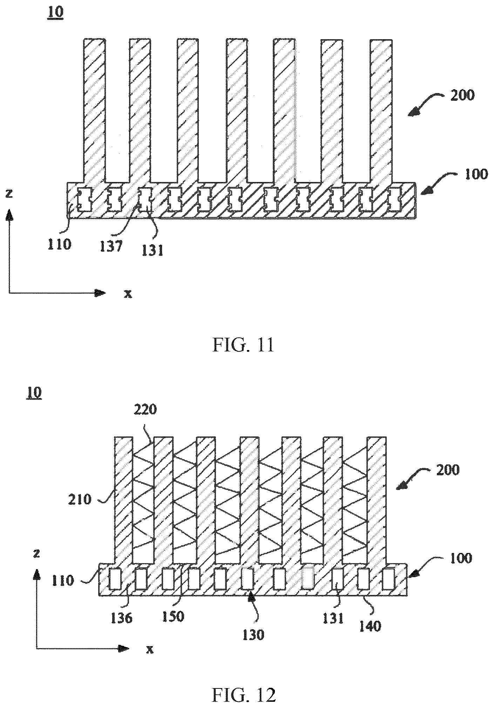

FIG. 11 is a schematic cross-sectional diagram of still another heat sink according to an embodiment of this application.

As shown in FIG. 11, in this embodiment of this application, the flow channel wall of the flow channel 131 has a concave-convex structure 137.

In this way, a heat exchange surface between the two-phase cooling medium 300 and the flow channel wall of the flow channel 131 is large, the heat exchange efficiency is high, and evaporation and condensation effect of the two-phase cooling medium 300 in the flow channel 131 are good.

It may be understood that, in an embodiment in which the thermally conductive plate 100 includes the plate member 110, the concave-convex structure 137 may extend to two ends of the plate member 110 in the second direction. Specifically, the concave-convex structure 137 may include at least one of a straight edge and a straight groove that extend in the second direction. The concave-convex structure 137, the separation part 136, the first side 140, and the second side 150 can be formed through one-time extrusion, in other words, the concave-convex structure 137 can be formed on the flow channel wall of the direct flow channel while the plate member 110 having a direct flow channel is formed through extrusion. The thermally conductive plate 100 is easy to manufacture and has low production costs.

As shown in FIG. 1 to FIG. 4, FIG. 8, FIG. 9, and FIG. 11, in this embodiment of this application, a first heat exchange structure 200 is disposed on the second side 150 of the thermally conductive plate 100.

It may be understood that the first heat exchange structure 200 is configured to perform heat exchange with the second side 150 and an environment outside the housing 21, and heat on the second side 150 may be transferred to the environment outside the housing 21 through the first heat exchange structure 200.

In this way, a heat dissipation area of the part that is of the heat sink 10 and that is located outside the housing 21 is increased, and heat dissipation effect of the heat sink 10 is good.

It may be understood that, after the heat sink 10 is assembled, the first heat exchange structure 200 is located outside the housing 21. In an embodiment in which the air duct shell 40 is disposed, the first heat exchange structure 200 is located inside the air duct 41, and the first heat exchange structure 200 is configured to perform heat exchange with air in the air duct 41.

It may be understood that the first heat exchange structure 200 and the second side 150 may be a split structure, and the first heat exchange structure 200 may be disposed on the second side 150 in a manner, for example, welding or bonding.

In this embodiment of this application, the first heat exchange structure 200 and the second side 150 are of an integrated structure.

In this way, in comparison with a solution in which the first heat exchange structure 200 and the second side 150 may be a split structure, when the first heat exchange structure 200 and the second side 150 are of an integrated structure, heat conduction efficiency between the first heat exchange structure 200 and the second side 150 is high. This facilitates heat dissipation of the heat sink 10.

In this embodiment of this application, two ends of the first heat exchange structure 200 extend in the second direction.

In this way, forming of the first heat exchange structure 200 is easy. This facilitates forming of the first heat exchange structure 200 through extrusion, and manufacturing costs of the heat sink 10 are low.

It may be understood that, in an embodiment in which the thermally conductive plate 100 includes the plate member 110, the first heat exchange structure 200 is disposed on a surface of the plate member 110, and the two ends of the first heat exchange structure 200 may respectively extend to two ends of the plate member 110. In this case, the first side 140, the second side 150, the separation part 136, and the first heat exchange structure 200 that are of an integrated structure may be formed through one-time extrusion, in other words, the first heat exchange structure 200 can be formed on the surface of the thermally conductive plate 100 while the plate member 110 having a direct flow channel is formed through extrusion.

Certainly, the first heat exchange structure 200 may alternatively be formed on the second side 150 through injection molding or the like. A shape and a molding manner of the first heat exchange structure 200 are not limited.

It may be understood that, when the first heat exchange structure 200 is formed without extrusion, an extension direction of the first heat exchange structure 200 may be oblique or perpendicular to the second direction.

For example, the first heat exchange structure 200 may include a first heat dissipation rib, the first heat dissipation rib is connected to the second side 150, two ends of the first heat dissipation rib may extend in the second direction, and the first heat dissipation rib and the thermally conductive plate 100 may be of an integrated structure.

In this embodiment of this application, the first heat exchange structure 200 includes a first toothed fin 210, and the first toothed fin 210 is connected to the second side 150.

It may be understood that the first toothed fin 210 may be configured to perform heat exchange with the second side 150 and the environment outside the housing 21.

In this way, a thickness of the first toothed fin 210 is thick. This facilitates heat transfer on the first toothed fin 210 in an extension direction of the first toothed fin 210, and facilitates temperature uniformity and heat dissipation of the first toothed fin 210. In addition, a size of the first toothed fin 210 in the thickness direction of the thermally conductive plate 100 is small. This helps reduce sizes of the heat sink 10 and the power conversion device.

It may be understood that a thickness of the first fin 210 may be set based on an actual application scenario. This is not specifically limited herein. For example, the thickness of the first toothed fin 210 may be greater than or equal to 1 mm and less than or equal to 3 mm.

In this embodiment of this application, the first toothed fin 210 and the second side 150 are of an integrated structure.

In this way, heat conduction efficiency between the first toothed fin 210 and the second side 150 is high. This facilitates heat dissipation of the heat sink 10.

In this embodiment of this application, the first toothed fin 210 is a straight toothed fin whose two ends extend in the second direction.

In this way, forming of the first toothed fin 210 is easy. This facilitates forming of the first toothed fin 210 through extrusion, and manufacturing costs of the heat sink 10 are low.

It may be understood that, in an embodiment in which the thermally conductive plate 100 includes the plate member 110, the first toothed fin 210 is disposed on the surface of the plate member 110, and two ends of the first toothed fin 210 may respectively extend to two ends of the plate member 110. In this case, the first side 140, the second side 150, the separation part 136, and the first toothed fin 210 that are of an integrated structure may be formed through one-time extrusion.

FIG. 12 is a schematic cross-sectional diagram of still another heat sink according to an embodiment of this application.

As shown in FIG. 12, in this embodiment of this application, the first heat exchange structure 200 may include a fin 220.

It may be understood that the fin 220 may be a straight fin with both ends extending in the second direction, to facilitate forming of the fin 220 when the second side 150 is formed through extrusion.

It may be understood that a thickness of the fin 220 may be set based on an actual application scenario. This is not specifically limited herein. For example, the thickness of the fin 220 may be greater than or equal to 0.08 mm and less than or equal to 0.1 mm.

In some embodiments of this application, the first heat exchange structure 200 includes a plurality of first toothed fins 210 that are spaced apart in the first direction. The first heat exchange structure 200 further includes the fin 220 disposed between two adjacent first toothed fins 210, and two ends of the fin 220 are respectively connected to the adjacent first toothed fins 210 on two sides.

It may be understood that two ends of the fin 220 are respectively configured to perform heat exchange with the connected first toothed fins 210, and the fin 220 is further configured to perform heat exchange with the environment outside the housing 21.

In this way, a distance between two adjacent first toothed fins 210 is small, and a heat dissipation area of the heat sink 10 provided with the first toothed fin 210 outside the housing 21 may be further increased by disposing the fin 220, so that the heat dissipation performance of the heat sink 10 is further improved. After the fin 220 is disposed, a size of the first toothed fin 210 in the thickness direction of the thermally conductive plate 100 may be reduced. This helps reduce sizes of the heat sink 10 and the power conversion device.

It may be understood that each first toothed fin 210 may be connected to the second side 150, and the first toothed fin 210 may be disposed perpendicular to the second side 150. The fin 220, whose two ends are respectively connected to adjacent first toothed fins 210 on two sides, is spaced apart from the second side 150 in the thickness direction of the thermally conductive plate 100, and the fin 220, whose two ends are respectively connected to the adjacent first toothed fins 210 on two sides, may be disposed parallel to or inclined to the second side 150.

It may be understood that the thickness of the fin 220 may be less than the thickness of the first toothed fin 210, the thickness of the fin 220 may be equal to the thickness of the first toothed fin 210, or the thickness of the fin 220 may be greater than the thickness of the first toothed fin 210.

It may be understood that a plurality of fins 220 may be spaced apart between two adjacent first toothed fins 210.

It may be understood that, the fin 220 and the adjacent first toothed fins 210 on two sides may be of an integrated structure, and the first side 140, the second side 150, the separation part 136, the first toothed fin 210, and the fin 220 that are of the integrated structure may be formed through one-time extrusion.

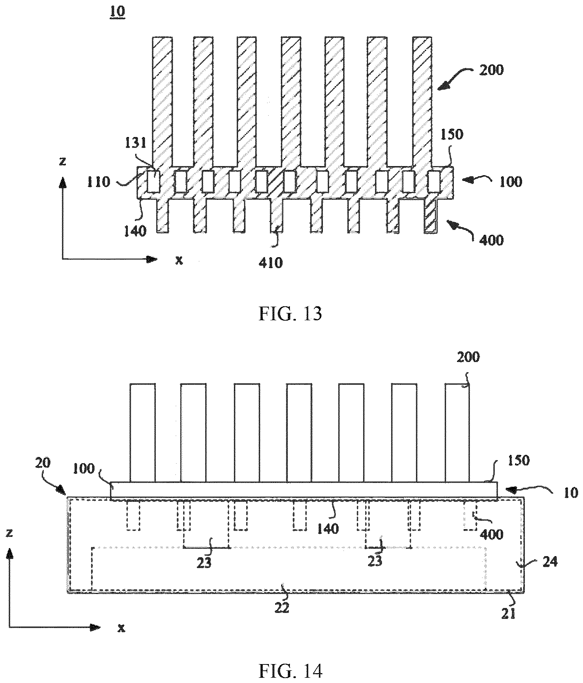

FIG. 13 is a schematic cross-sectional diagram of still another heat sink according to an embodiment of this application. FIG. 14 is a schematic perspective diagram of a power conversion module and a heat sink of still another power conversion device on a side in a second direction according to an embodiment of this application.

As shown in FIG. 13 and FIG. 14, in this embodiment of this application, a second heat exchange structure 400 is disposed on the first side 140 of the thermally conductive plate 100.

It may be understood that after the heat sink 10 is assembled, the second heat exchange structure 400 is located in the housing 21, and the second heat exchange structure 400 is configured to perform heat exchange with the first side 140 and an environment in the housing 21.

In this way, a heat exchange area of a part that is of the heat sink 10 and that is located in the housing 21 is increased, heat in the housing 21 is transferred to the outside of the housing 21 by using the heat sink 10, and a temperature in the housing 21 is reduced.

It may be understood that the second heat exchange structure 400 and the first side 140 may be a split structure, and the second heat exchange structure 400 may be disposed on the first side 140 in a manner, for example, welding or bonding.

In this embodiment of this application, the second heat exchange structure 400 and the first side 140 are of an integrated structure.

In this way, in comparison with a solution in which the second heat exchange structure 400 and the first side 140 may be a split structure, when the second heat exchange structure 400 and the first side 140 are of an integrated structure, heat conduction efficiency between the second heat exchange structure 400 and the first side 140 is high. This facilitates transfer of heat in the housing 21 to the outside of the housing 21.

In this embodiment of this application, the two ends of the first heat exchange structure 200 extend in the second direction.

In this way, forming of the second heat exchange structure 400 is easy. This facilitates forming of the second heat exchange structure 400 through extrusion, and manufacturing costs of the heat sink 10 are low.

It may be understood that, in an embodiment in which the thermally conductive plate 100 includes the plate member 110, the second heat exchange structure 400 is disposed on the surface of the plate member 110. In this case, the first side 140, the second side 150, the separation part 136, and the second heat exchange structure 400 that are of an integrated structure may be formed through one-time extrusion, in other words, the second heat exchange structure 400 may be formed on the surface of the thermally conductive plate 100 while the plate member 110 having the direct flow channel is formed through extrusion.

It may be understood that the plate member 110 having the direct flow channel, the concave-convex structure 137 on the flow channel wall, the first heat exchange structure 200, and the second heat exchange structure 400 may be of an integrated structure. The plate member 110 having the direct flow channel, the concave-convex structure 137 on the flow channel wall, the first heat exchange structure 200, and the second heat exchange structure 400 may be formed through one-time extrusion.

Certainly, the second heat exchange structure 400 may alternatively be formed on the first side 140 through injection molding or the like. A shape and a molding manner of the second heat exchange structure 400 are not limited.

It may be understood that, when the second heat exchange structure 400 is formed without extrusion, an extension direction of the second heat exchange structure 400 may be oblique or perpendicular to the second direction.

For example, the second heat exchange structure 400 may include a second heat dissipation rib, the second heat dissipation rib is connected to the first side 140, two ends of the second heat dissipation rib may extend in the second direction, and the second heat dissipation rib and the thermally conductive plate 100 may be a dual-body structure.

In this embodiment of this application, the second heat exchange structure 400 includes a second toothed fin 410, and the second toothed fin 410 is connected to the first side 140.

It may be understood that the second toothed fin 410 may be configured to perform heat exchange with the first side 140 and the environment in the housing 21.

In this way, a thickness of the second toothed fin 410 is thick. This facilitates heat transfer on the second toothed fin 410 in an extension direction of the second toothed fin 410, and facilitates temperature uniformity and heat dissipation of the second toothed fin 410. In addition, a size of the second toothed fin 410 in the thickness direction of the thermally conductive plate 100 is small. This facilitates arrangement in the housing 21.

It may be understood that the thickness of the second toothed fin 410 may be set based on an actual application scenario. This is not specifically limited herein. For example, the thickness of the second toothed fin 310 may be greater than or equal to 1 mm and less than or equal to 3 mm.

It may be understood that, in an embodiment in which the first toothed fin 210 and the second toothed fin 410 are disposed, a size of the first toothed fin 210 may be greater than a size of the second toothed fin 410 in the thickness direction of the thermally conductive plate 100.

In this embodiment of this application, the second toothed fin 410 and the first side 140 are of an integrated structure.

In this way, heat conduction efficiency between the second toothed fin 410 and the first side 140 is high, and heat in the housing 21 is transferred to the outside of the housing 21.

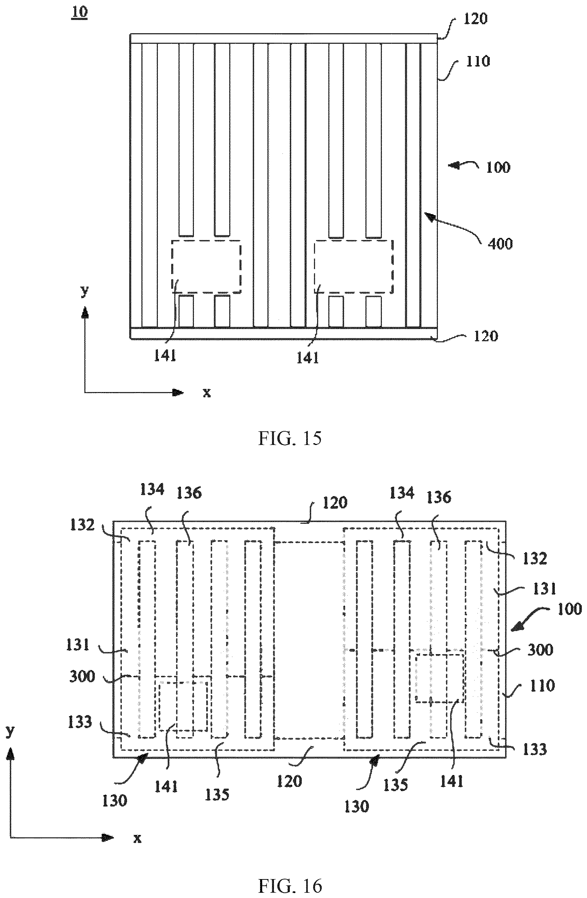

FIG. 15 is a schematic diagram of still another heat sink on a side that a first side faces according to an embodiment of this application.

As shown in FIG. 15 and with reference to FIG. 13 and FIG. 14, in this embodiment of this application, the second toothed fin 410 is a straight toothed fin whose two ends extend in the second direction.

In this way, forming of the second toothed fin 410 is easy. This facilitates forming of the second toothed fin 410 through extrusion, and manufacturing costs of the heat sink 10 are low.

It may be understood that, in an embodiment in which the thermally conductive plate 100 includes the plate member 110, the second toothed fin 410 is disposed on the surface of the plate member 110. In this case, the first side 140, the second side 150, the separation part 136, and the second toothed fin 410 that are of an integrated structure may be formed through one-time extrusion.

In this embodiment of this application, the second heat exchange structure 400 is located outside the heat source assembly region 141.

In this way, it is convenient to assemble the power element 23 on the first side 140 having the second heat exchange structure 400, so that the second heat exchange structure 400 has little effect on the arrangement of the power element 23.

It may be understood that the heat source assembly region 141 may be a plane structure, and a shape of the heat source assembly region 141 may be set based on a shape of a to-be-mounted power element 23, so that the power element 23 may fit or be as close as possible to the heat source assembly region 141, and efficient heat exchange can be performed between that power element 23 and the heat source assembly region 141.

It may be understood that the second heat exchange structure 400 may be first formed on the surface of the plate member 110 through extrusion, and then a part that is of the second heat exchange structure 400 and that is located in the heat source assembly region 141 is machined, to remove the part that is of the second heat exchange structure 400 and that is located in the heat source assembly region 141 on the first side 140.

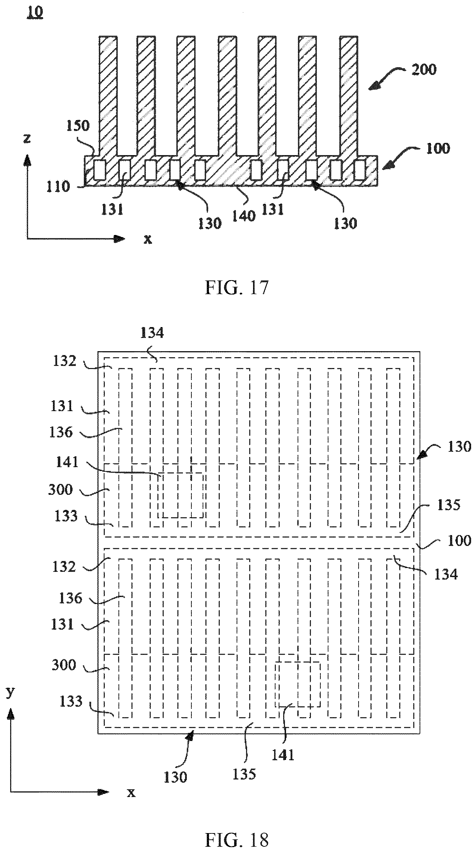

FIG. 16 is a schematic perspective diagram of a thermally conductive plate of still another heat sink on a side that a second side faces according to an embodiment of this application. FIG. 17 is a schematic cross-sectional diagram of still another heat sink according to an embodiment of this application.

As shown in FIG. 16 and FIG. 17, in this embodiment of this application, the thermally conductive plate 100 has at least two chambers 130, and different chambers 130 are separated from each other.

In this way, when the first ends 132 of all the flow channels 131 meet and the second ends 133 of all the flow channels 131 meet in the same chamber 130, liquid levels of two-phase cooling media 300 in different chambers 130 are at different heights. When the first side 140 of the thermally conductive plate 100 has a plurality of heat source assembly regions 141 at different heights, power elements 23 at the heat source assembly regions 141 at different heights can be located below the liquid levels of the two-phase cooling media 300 in the corresponding chamber 130, so that heat emitted by the power elements 23 at different heights can be absorbed by the two-phase cooling medium 300 in the liquid phase. A capacity of the two-phase cooling medium 300 in the liquid phase in each chamber 130 is small. Therefore, the two-phase cooling medium 300 in the liquid phase in each chamber 130 is easily evaporated after absorbing heat emitted by the power element 23 at a corresponding position. This facilitates heat transfer at each power element 23 by a phase change of the two-phase cooling medium 300 when a plurality of power elements 23 have different heights.

In an embodiment in which the thermally conductive plate 100 has at least two chambers 130, all the chambers 130 in the thermally conductive plate 100 are spaced apart in the first direction.

In this way, it is convenient to form a plurality of chambers 130 separated from each other between the plate member 110 having a direct flow channel and the end covers 120 at two ends of the plate member 110 through extrusion, and it is convenient to form a plurality of chambers 130 separated from each other.

FIG. 18 is a schematic perspective diagram of a thermally conductive plate of still another heat sink on a side that a second side faces according to an embodiment of this application.

As shown in FIG. 18, in an embodiment in which the thermally conductive plate 100 has at least two chambers 130, the at least two chambers 130 in the thermally conductive plate 100 may be spaced apart in the second direction.

In this way, when power elements 23 need to be disposed at positions with different heights on the thermally conductive plate 100, a capacity of a two-phase cooling medium 300 in the chamber 130 corresponding to the power element 23 at a higher position may be smaller, thereby facilitating heat transfer. In addition, when power elements 23 need to be disposed at positions with different heights on the thermally conductive plate 100, a size of the thermally conductive plate 100 in the first direction may be small.

It may be understood that projections, on the second direction, of a plurality of chambers 130 that are spaced apart in the second direction may overlap each other.

It may be understood that a partition member like a partition plate may be disposed between two adjacent chambers 130 that are spaced apart in the second direction, and the two adjacent chambers 130 that are spaced apart in the second direction may be separated from each other by using a partition member like a partition plate.

In descriptions of embodiments of this application, it should be noted that, unless otherwise clearly specified and limited, terms "mounting", "connection to", and "connection" should be understood in a broad sense. For example, the connection may be a fixed connection, may be an indirect connection by using an intermediate medium, or may be an internal connection between two elements or an interaction relationship between two elements. A person of ordinary skill in the art may understand specific meanings of the terms in embodiments of this application based on specific cases.

In the specification, claims, and accompanying drawings of embodiments of this application, the terms "first", "second", "third", "fourth", and so on (if existent) are intended to distinguish between similar objects but do not necessarily indicate a specific order or sequence.

Finally, it should be noted that the foregoing embodiments are merely used to describe the technical solutions in embodiments of this application, but not to limit the technical solutions. Although embodiments of this application are described in detail with reference to the foregoing embodiments, a person of ordinary skill in the art should understand that the technical solutions recorded in the foregoing embodiments may still be modified, or some or all of technical features thereof may be equivalently replaced. However, these modifications or replacements do not depart from the scope of the technical solutions in embodiments of this application.

## Claims

1. A power conversion device, comprising a housing, a power element, and a heat sink, wherein
a mounting cavity is formed in the housing, and the power element is mounted in the mounting cavity;
the heat sink comprises a thermally conductive plate, the thermally conductive plate is mounted in the housing, the thermally conductive plate comprises a first side in a thickness direction of the thermally conductive plate, the first side has a heat source assembly region, and the power element is disposed in the heat source assembly region and is in thermal contact with the thermally conductive plate;
the thermally conductive plate has at least one sealed chamber, the chamber is provided with at least two flow channels spaced apart in a first direction, and a two-phase cooling medium is accommodated in the flow channel;
the flow channel comprises a first end and a second end, the first end and the second end are spaced apart in a second direction, and the first end is located above the second end; and
both the first direction and the second direction are perpendicular to the thickness direction of the thermally conductive plate, and the first direction is perpendicular to the second direction.

2. The power conversion device according to claim 1, wherein in the same chamber, first ends of all the flow channels meet, and second ends of all the flow channels meet.

3. The power conversion device according to claim 2, wherein the chamber comprises a first sub-cavity and a second sub-cavity; and
in the same chamber, the first sub-cavity is located at an upper end of the chamber, the second sub-cavity is located at a lower end of the chamber, the flow channel is located between the first sub-cavity and the second sub-cavity, the first end of the flow channel is communicated with the first sub-cavity, the first ends of all the flow channels meet by using the first sub-cavity, the second end of the flow channel is communicated with the second sub-cavity, and the second ends of all the flow channels meet by using the second sub-cavity.

4. The power conversion device according to claim 2 or 3, wherein a confluence channel is disposed between at least one pair of two adjacent flow channels in the same cavity, and two ends of the confluence channel are respectively communicated with the two adjacent flow channels; and
in the same flow channel, an intersection of the confluence channel and the flow channel is located below the first end and above the second end.

5. The power conversion device according to any one of claims 2 to 4, wherein there are at least two chambers in the thermally conductive plate, and different chambers are separated from each other.

6. The power conversion device according to any one of claims 1 to 5, wherein the thermally conductive plate further comprises a second side opposite to the first side; and
there is a separation part between two adjacent flow channels, two ends of the separation part in the thickness direction of the thermally conductive plate are respectively connected to the first side and the second side, and the flow channel is formed between the separation part and a chamber wall of the chamber.

7. The power conversion device according to claim 6, wherein the separation part, the first side, and the second side are of an integrated structure.

8. The power conversion device according to any one of claims 1 to 7, wherein the flow channel is a direct flow channel extending in the second direction.

9. The power conversion device according to claim 8, wherein the thermally conductive plate comprises a plate member and an end cover, the flow channel is located in the plate member, and the flow channel passes through two ends of the plate member in the second direction; and
the two ends of the plate member in the second direction are covered with end covers, and the chamber is formed between the end covers of the two ends of the plate member and an inner wall of the plate member.

10. The power conversion device according to any one of claims 1 to 9, wherein a flow channel wall of the flow channel has a concave-convex structure.

11. The power conversion device according to any one of claims 1 to 10, wherein a first heat exchange structure is disposed on the second side of the thermally conductive plate.

12. The power conversion device according to claim 11, wherein the first heat exchange structure comprises a first toothed fin, and the first toothed fin is connected to the second side.

13. The power conversion device according to claim 12, wherein the first toothed fin is a straight toothed fin whose two ends extend in the second direction.

14. The power conversion device according to any one of claims 11 to 13, wherein the first heat exchange structure comprises a plurality of first toothed fins that are spaced apart in the first direction; and
the first heat exchange structure further comprises a fin disposed between two adjacent first toothed fins, and two ends of the fin are respectively connected to the adjacent first toothed fins on two sides.

15. The power conversion device according to any one of claims 1 to 14, wherein a second heat exchange structure is disposed on the first side.

16. The power conversion device according to claim 15, wherein the second heat exchange structure comprises a second toothed fin, and the second toothed fin is connected to the first side.

17. The power conversion device according to claim 16, wherein the second toothed fin is a straight toothed fin whose two ends extend in the second direction.

18. The power conversion device according to any one of claims 15 to 17, wherein the second heat exchange structure is located outside the heat source assembly region.

19. A heat sink, comprising a thermally conductive plate, wherein
the thermally conductive plate has at least one sealed chamber, the chamber is provided with at least two flow channels spaced apart in a first direction, and a two-phase cooling medium is accommodated in the flow channel;
the flow channel comprises a first end and a second end, and the first end and the second end are spaced apart in a second direction; and
both the first direction and the second direction are perpendicular to a thickness direction of the thermally conductive plate, and the first direction is perpendicular to the second direction.
